# Europäisches Patentamt

## European Patent Office

## Office européen des brevets

(11) Publication number: **0 106 598**

**B1**

(12) **EUROPEAN PATENT SPECIFICATION**

(45) Date of publication of patent specification: **14.12.88**

(51) Int. Cl.⁴: **H 01 L 21/60**

(21) Application number: **83305866.2**

(22) Date of filing: **29.09.83**

(54) Fluxless bonding of microelectronic chips.

(30) Priority: **08.10.82 US 433382**

(43) Date of publication of application:
**25.04.84 Bulletin 84/17**

(45) Publication of the grant of the patent:
**14.12.88 Bulletin 88/50**

(84) Designated Contracting States:
**DE FR GB**

(56) References cited:
**EP-A-0 007 873
FR-A-2 120 018
FR-A-2 235 752
GB-A- 851 544
US-A-4 142 662**

**IBM TECHNICAL DISCLOSURE BULLETIN, vol.
23, no. 7A, December 1980, page 2990, New
York, USA; D.A. CHANCE: "Fluxless C4 joints
and reflow without degradation"**

(73) Proprietor: **Western Electric Company,
Incorporated
222 Broadway
New York, NY 10038 (US)**

(72) Inventor: **Henein, Gerard Edmond
16 Ridge Drive
Berkeley Heights New Jersey 07922 (US)**
Inventor: **Hepplewhite, Ralph Thomas
73 West Rayburn Road
Millington New Jersey 07946 (US)**
Inventor: **Schwartz, Bertram
321 Orenda Circle
Westfield New Jersey 07090 (US)**

(74) Representative: **Johnston, Kenneth Graham
et al
AT&T (UK) LTD. AT&T Intellectual Property
Division 5 Mornington Road
Woodford Green Essex, IG8 OTU (GB)**

Courier Press, Leamington Spa, England.

EP 0 106 598 B1

## Description

This invention relates to the bonding of microelectronic chips to an electrically conducting bonding surface.

A semiconductor laser is a tiny device typically measuring only about 250 μm in width across the mirror facets and about 400 μm in length along the optical resonator. The active region of the laser, where recombination of holes and electrons generates stimulated emission, is even smaller. In a typical stripe geometry, double heterostructure (DH) laser the active region may be only 3—5 μm wide, 0.1—0.2 μm thick and 400 μm long. As a consequence, when a typical pumping current of, say, 100 mA, is applied to the laser, the current density in the active region may be of the order of 5000 A/cm². Since the lasers are commonly operated continuous wave at or near room temperature, appreciable heating occurs. Excessive heating, of course, would damage the laser.

In order to prevent such damage, the removal of heat from the laser chip is facilitated by bonding the chip to a suitable heat sink, which is commonly made of a high thermal conductivity material (e.g., copper or diamond). However, the bonding operation must be performed carefully so as to avoid inducing in the laser chip excessive strain which, it has been found, is deleterious to laser reliability and lifetime. That is, the common laser substrate materials, GaAs and InP, are brittle and may crack under undue stress, e.g., $10^8$ Pa ($10^9$ dyn/cm²). Moreover, stress may generate defects in the active region or cause defects to migrate to the active region.

Thus, thermo-compression and ultrasonic chip bonding, widely used techniques in the other semiconductor fields, have been largely rejected in the semiconductor laser art in favor of soldering in the presence of a corrosive flux. In this method, a thick gold bonding pad is deposited on the ohmic contact on one side of the laser chip, and a thin gold layer is formed on a Cu stud (heat sink). A thick layer of a soft, ductile, low melting point metal (commonly indium) is evaporated onto the gold layer on the stud and is then placed in contact with the gold bonding pad. A small weight (e.g., 5 gm) is lowered onto the chip, and the stud temperature is raised to about 280°C in an atmosphere of forming gas in order to melt the indium and to bond the chip to the stud. However, the indium layer tends to oxidize before the bond is completed, and oxides in the bond area increase heat generation because of their high electrical resistivity and poor thermal conductivity. Also, because the melting point of the oxide is higher than that of the solder, the presence of a solid surface oxide prevents the solder from wetting at the bonding temperature. In order to insure ease and reproducibility in realizing these bonds, and to keep electrical conductance high, a liquid flux (e.g., $ZnCl_2$—$NH_4Cl$—$H_2O$) is used to dissolve the indium oxide and allow the liquid indium to flow and wet the gold on the laser chip.

This flux soldering procedure has several drawbacks, however. First, the danger exists of chlorine-containing residues becoming trapped within the bond. $ZnCl_2$, for instance, transforms into ZnO, Zn(OH)Cl and HCl in the presence of small amounts of water and thus is a potential corrosive agent in devices operated in humid ambients. Second, the flux boils at the required bonding temperature of 260—280°C and becomes a carrier for liquid indium droplets which, if they hit the sides of the chip, can produce a short-circuit or cause interference with the light beam exiting the laser facet. Third, voids 20—100 μm in size are created during bonding by bubbles of boiling flux entrapped inside the indium. These voids can drastically affect heat removal in the bond area because they represent barriers of practically infinite thermal resistance. If located directly under the active region, voids can raise the junction temperature considerably: theoretical calculations show that a 30 μm void raises the junction temperature by 7.8°C and a 100 μm void by 47.5°C. Fourth, the bonds are frequently incompletely wetted; i.e., the actual bond area is smaller than the gold bonding pad. This shortcoming may be due to improper application of the flux which is applied manually and hence is very operator dependent. Fifth, the bonds frequently contain large amounts of Au-In intermetallic compounds (e.g., $Au_4In$, $Au_9In$, $AuIn$, and $AuIn_2$) which can result in hard bonds. The absence of a pure indium layer after bonding or the presence of the harder intermetallic compounds allows *thermal stresses* (due to the difference in thermal expansion coefficients between the heat sink and the laser) as well as intrinsic stresses (induced by the presence of the intermetallics) to be transmitted to the active region of the laser.

IBM TDB Vol. 23, No. 7A December 1980 page 2990 discloses a method of bonding a microelectronic chip to a support without using a flux. The bonding is effected in a non-oxidizing ambient whose purpose is to prevent the formation of any oxides on the bonding material.

Forming low-stress, void-free bonds is also of interest with other microelectronic chips, for example, LEDs which are bonded to a metallic header.

According to the present invention there is provided a method of manufacturing a device in which a metal layer on a microelectronic chip is bonded to a metallized support member, the method comprises providing a soft ductile bonding layer on at least one of the metal layer and the support member, the bonding layer having a tendency to form an oxide thereon, positioning the assembly of the support member, the chip and the bonding layer(s) in an evacuable chamber without any liquid flux, on the bonding layer(s), introducing gas into the chamber so that oxidation of the bonding layer is minimized, and heating the bonding layer(s) to above the melting point thereof, characterised in that the said gas functions as a reducing gas to reduce the oxide(s) on the said bonding layer(s) with the consequent generation of a gaseous reduction product, in that the pressure in the chamber is reduced to a subatmospheric pressure(s) in order to decrease the partial pressure of the said gaseous reduction product, in that the parts of the assembly can be brought into contact at any time, and in that the gas, the temperature of the heating, and the reduced pressure are such that the said gas functions as the reducing gas.

We have found that reproducible, low-strain, void-free, completely wetted, bonds between semiconductor laser chips and their heat sinks can be realized by a fluxless technique using a reducing gas. An embodiment method, carried out in a vacuum chamber, entails the use of a soft, ductile metal, in the presence of the reducing gas such as CO or substantially pure $H_2$, to solder a metalized heat sink to a metal layer on the chip. Preferably, the soft, ductile metal is indium and the heat-sink is heated to a temperature in the range of about 180—240°C when CO is used and in the range of about 220—230°C when $H_2$ is used. LEDs and other microelectric chips can be bonded to a bonding surface, for example a header, in similar fashion.

The invention can be readily understood from the following, more detailed description taken in conjunction with the accompanying drawing, in which:

Figure 1 is a schematic drawing showing a semiconductor laser chip and a heat sink positioned in a vacuum chamber for bonding in accordance with one embodiment of our invention;

Figure 2 is a graph showing the temperature-time profile during an illustrative bonding operation; and

Figure 3 shows a representative distribution of stress in chips bonded at various temperatures in embodiments of the invention.

### 1. Thermodynamics

Before discussing the step-by-step procedures employed in practicing our invention, it will be instructive to consider first the thermodynamics of the reduction of the oxide which forms on the soft, ductile metal used to effect the bond: indium sesquioxide in the case where indium is the metal, and tin dioxide in the case where tin (usually a Sn-Au alloy) is the metal. Based on the thermodynamics of indium sesquioxide (the stable form at room temperature), hydrogen and carbon monoxide were chosen as the reducing gases. The reaction with hydrogen at the bonding temperature is:

$$In_2O_3+3H_2(g)\rightleftarrows2In(l)+3H_2O(g) \qquad (1)$$

The free energy $\Delta F_T$ of the reduction reaction is expressed as:

$$\Delta F_T=\Delta F^0_T+RTLnK \qquad (2)$$

where

$$K=(P_{H_2O}/P_{H_2})^3 \qquad (3)$$

Equation (3) shows that the equilibrium constant K is the cube of the ratio of the partial pressures of water vapor and hydrogen, $\Delta F^0_T$ is the free energy at 25°C and R is the ideal gas constant. In order for the reduction reaction to proceed at temperature T, a necessary condition is:

$$\Delta F_T<0;$$

that is,

$$P_{H_2O}/P_{H_2}<exp(-\Delta F^0_T/3RT) \qquad (4)$$

For analytic purposes, a nominal bonding temperature of 200°C was chosen as a compromise between two opposing tendencies: the reduction reaction becomes faster with increasing temperature, but the bonded devices become more strained. It has been established that the threshold for the occurrence of high strains in flux-bonded devices is 200°C, as evidenced by the photoelastic effect. Literature values of $\Delta F^0_T$ at 200°C average to 26.5 ($\pm$3%) kcal/mole. The value of $P_{H_2O}/P_{H_2}$ calculated from Eq. (4) is $9\times10^{-5}$ ($\pm$25%). A value of this partial pressure ratio $\leq9\times10^{-5}$ is therefore suitable.

The reaction with carbon monoxide is similar to the one with hydrogen,

$$In_2O_3(s)+3CO(g)\rightleftarrows2In(l)+3CO_2(g) \qquad (5)$$

A free energy of 11 kcal/mole was calculated from the free-energies of formation of $In_2O_3$, CO and $CO_2$ at 200°C. The calculated value of $P_{CO_2}/P_{CO}$ is $2\times10^{-2}$. As before, a value of this partial pressure ratio $\leq2\times10^{-2}$ is therefore suitable.

The partial pressure ratios indicate that the reduction of $In_2O_3$ is possible provided a high enough vacuum is created in the bonding chamber and that pure enough gases are used. More specifically, if a base vacuum of $1.33\times10^{-3}$ Pa ($10^{-5}$ Torr) is used, then $P_{CO_2}/P_{CO}=2\times10^{-2}$ translates into a minimum $P_{CO}$ of about 0.05 Pa (0.5 $\mu$m) and $P_{H_2O}/P_{H_2}$ translates into a minimum $P_{H_2}$ of about 10 Pa (100 $\mu$m). However, the thermodynamics favor reduction with CO more than with $H_2$. Similar considerations apply to the reduction of $SnO_2$ where

$$P_{CO_2}/P_{CO}=1.08$$

and

$$P_{H_2O}/P_{H_2}=1\times10^{-2}$$

at 232°C (the melting point of Sn).

### 2. Experimental procedure

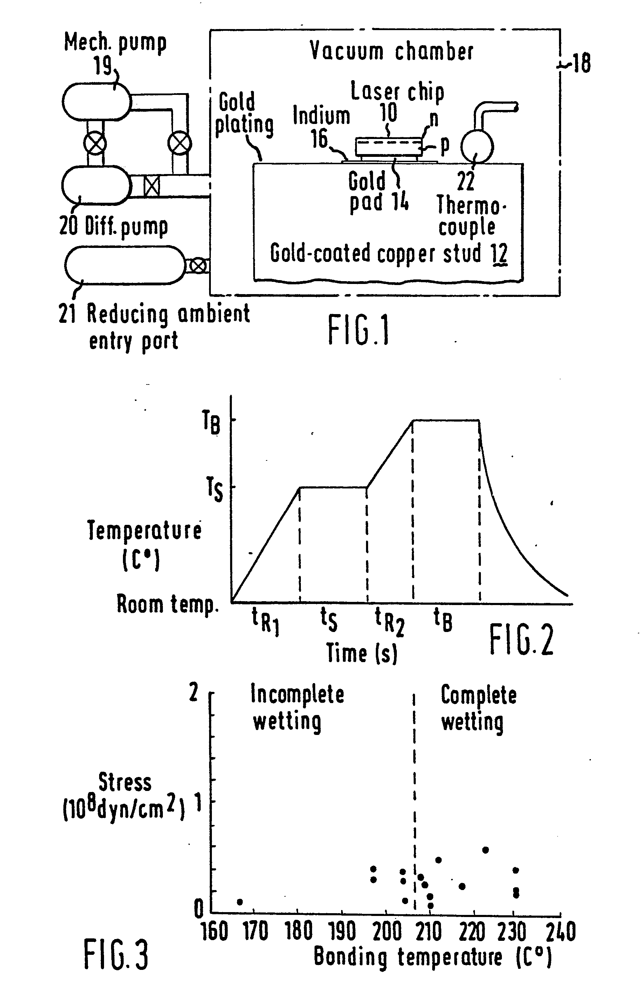

In accordance with one embodiment of our invention, and as shown in Figure 1, an AlGaAs DH semiconductor laser chip 10 was bonded to Au-plated Cu heat sink (or stud) 12. A gold bonding pad 14 was electroplated on the p-side electrical contact (Ti-Pt) of the laser chip, and a layer 16 of In solder was evaporated onto the top of the stud 12. However, it is possible (although not preferable) to form the In layer 16 on the bonding pad 14 instead of on stud 12. This procedure would entrail forming the In layer prior to chip separation and would require care to keep In off of the laser mirrors.

The bonding was done in a vacuum chamber 18 consisting of a bell-jar (not shown) evacuated by a mechanical pump 19 and diffusion pump 20. The stud was held between two spring-loaded, graphite electrodes (not shown). An electrical current applied to these electrodes provided resistive heating of the stud 12 and In layer 16. The surface temperature of the stud was measured with a Pt-PtRh thermocouple 22 in physical contact with the stud surface. To eliminate systematic errors, the thermocouple was calibrated in place in both CO and $H_2$ using the melting points of In on a Au-plated stud and of Sn and Pb on bare Cu studs.

After the gold pad 14 of the laser chip 10 had been positioned on the indium layer 16 on stud 12, the pressure of the vacuum chamber was reduced to about 1.33 Pa ($10^{-2}$ Torr) using the mechanical pump 19 and was then backfilled three times with the reducing gas through entry port 21. The chamber pressure was then reduced to about $1.33 \times 10^{-3}$ Pa ($10^{-5}$ Torr) using the diffusion pump 20 and backfilled again. After a final pumpdown to about $1.33 \times 10^{-3}$ Pa ($10^{-5}$ Torr) using the diffusion pump 20, the reducing gas was admitted to the chamber through port 21 up to a pressure of 15—20 Pa (150—200 μm Hg). The bond was then made by applying power to the graphite electrodes. The time-temperature cycle (Figure 2) was composed of five parts: a first ramp (duration $t_{R_1}$) from room temperature to the melting point of $T_s$ of indium (157°C); a first plateau (duration $t_s$) at the melting point; a second ramp (duration $t_{R_2}$) to the bonding temperature $T_B$; a second plateau (duration $t_B$) at the bonding temperature; and a fast cool-down to room temperature. In some cases the cycle had only three parts; that is, $t_s=0$ and the temperature was raised from room temperature to the bonding temperature directly. All of the devices used in the initial studies were AlGaAs DH lasers, although this fluxless bonding technique has been used equally well with InGaAsP/InP lasers.

If a manipulator is available inside the chamber, it is possible to keep the chip and In layer separate from one another until time $t_{R_1}+t_s+t_{R_2}$ when contact is effected between the chip and the melted solder.

### 3. Results with carbon monoxide

Our initial set of experiments utilized a 5 μm thick In layer, a 12 μm thick gold pad, and a 3-part time temperature cycle with $t_s=0$, $t_{R_1}+t_{R_2}=20$—25 sec. and $t_B=5$—25 sec. The bonding temperature $t_B$ ranged from 158°C—276°C. The strains generated in the laser chip during bonding were imaged in an infra-red (IR) microscope using the photoelastic effect. The results indicated that it is possible to bond chips without liquid flux in a CO ambient in the range of temperatures 180—275°C with bonding times as low as 5 seconds. Below 180°C the bonds were nonreproducible. However, bonds with low strain, i.e. less than about $10^7$ Pa ($10^8$ dyn/cm$^2$) were achieved in the range of about 180—240°C. In comparison, stress of the order of $10^8$ Pa ($10^9$ dyn/cm$^2$) has been shown to induce ductile fracture in the epitaxial layers of a laser chip.

In another set of experiments we studied the influence of the bonding temperature and time and of the presence or absence of a weight resting on the chip on the following parameters: wetting, void content, bond nature (soft vs. hard) and induced stress (measured using single crystal x-ray diffractometry in the Automatic Bragg Angle Control (ABAC) mode, rather than using an IR microscope and the photoelastic effect. The bonding temperature $T_B$ varied between 167 and 230°C and the bonding time $T_B$ between 25 and 150 sec. Different temperature profiles were examined: ramp ($t_s=0$; $t_{R_1}=25$—60 sec.); ramp and soak at the bonding temperature ($t_{R_1}=20$—35 sec., $t_s=30$ sec., $t_{R_2}=25$ sec.); ramp and soak at temperature $T_s$; and slow cooling.

The devices had a 200 nm (2000 Å) thick gold bonding pads 14, and studs 12 were covered with a 1 μm thick electroplated gold layer followed by a 9 μm thick layer 16 of evaporated indium. Bonding was achieved, as before, by bringing the stud to temperature under a flow of CO at a pressure of 133 Pa (1 Torr) (1000 μm Hg) after several pump-down-backfill cycles including a final pumpdown to about $2.66 \times 10^{-3}$ Pa ($2 \times 10^{-5}$ Torr). A ratio of the partial pressures

$$P_{co_2}/P_{co} \leq 2 \times 10^{-5}$$

ensured the reduction of indium oxide $In_2O_3$ at temperatures around 200°C.

The use of a 5 gram weight resting on the laser during bonding was found to be detrimental. In most instances, molten indium was squeezed out from under the chip resulting in a partly or wholly intermetallic bond. Such bonds induced nonuniform stresses in the device. In contrast, an ABAC scan taken of a chip bonded under the same conditions of temperature and time, but without weight, exhibited a low and very uniform level of stress along the device, viz. $<0.2 \times 10^7$ Pa ($<0.2 \times 10^8$ dyn/cm$^2$).

Practically no influence on the bonding temperature-time profile was observed within the range studied. The only exception was a 60 sec. slow cool from 230 to 100°C which induced nonuniform and high stresses in the device. In contrast, a single bonding ramp ($t_{R_1}+t_{R_2}$) as short as 25 sec. yielded a satisfactory bond.

A marked influence of the temperature was observed upon the wetting characteristics. Chips bonded at 204°C and below showed, upon debonding, that incomplete wetting of the gold pad had occurred (island-like wetting), irrespective of the bonding time. Chips bonded at 208°C and above exhibited complete wetting of the gold pad by the indium.

Bonding temperatures between 208 and 223°C reproducibly kept the stress in the chips to values lower than $0.6 \times 10^7$ Pa ($0.6 \times 10^8$ dyn/cm²); i.e., such temperatures did not significantly affect the stress level, as compared with that present in the chips prior to bonding. Bonding-induced stresses stated to reach significant values at about 230°C where values as high as $1.2 \times 10^7$ Pa ($1.2 \times 10^8$ dyn/cm²) were reached. The values of the stresses in weightless- and fluxless-bonded chips are plotted versus bonding temperature in Figure 3.

Our fluxless bonding technique results in entirely void-free bonds in every instance when complete wetting is achieved (i.e., above 204°C).

In addition, the technique is very clean in that no creeping of indium on the saw-cut faces of the chips nor any spattering of indium on the mirror facets was ever observed. This result is again in contrast with the flux bonding technique in which the liquid flux acts as a carrier for indium droplets.

In summary, our fluxless bonding technique is capable of reproducibly yielding good quality, void-free and adequately wetted bonds with a bonding temperature 75°C below that ordinarily used for flux bonding (205 vs. 280°C). The stresses induced in the device by this technique can reproducibly be kept below $0.6 \times 10^7$ Pa ($0.6 \times 10^8$ dyn/cm²).

### 4. Results with hydrogen

These experiments were performed using chips and procedures (i.e., IR microscopy) of the type employed in the initial experiment with CO. The bonding strains induced in the device were high above ⁻250°C and moderate to low below this temperature. Low-stress bonds occurred in the range of about 220—230°C.

Three differences can be noted as compared with the results obtained in CO. First, the lowest temperature leading to a bond was higher (220°C in $H_2$, 180°C in CO), which is consistent with the difference between the free-energies of the reduction of $In_2O_3$ by CO and $H_2$. Second, all the shear tests left the bonds unaffected by a force of 150 grams indicating that the conversion of indium to Au-In intermetallics was more complete in the presence of $H_2$. That is, the interdiffusion between Au and In was faster. This conclusion is in agreement with the observation that diffusion rates in solids are strongly dependent on the annealing ambient. Third, the range of temperatures over which low-strain bonds achieved was narrower: 220—230°C in $H_2$ but 180—240°C in CO.

As with CO, the meniscus formed by liquid indium between the gold pad and the stud was much smaller for $H_2$-bonded lasers than for lasers bonded using a liquid flux.

It is to be understood that the above-described arrangements are merely illustrative of the many possible specific embodiments which can be devised to represent application of the invention. Numerous and varied other arrangements can be devised. In particular, we expect similar results with Sn-alloy. solders, In-alloy solders, and with InP/InGaAsP laser chips. Moreover, other microelectronic chips can be bonded to a metalized support member (e.g., header or heat sink) using our technique. Finally, besides resistance heating, other techniques, such as RF heating or radiation (laser) heating, can be employed to effect the fluxless bond.

### Claims

1. A method of manufacturing a device in which a metal layer (14) on a microelectronic chip (10) is bonded to a metallized support member (12), the method comprises providing a soft ductile bonding layer (16) on at least one of the metal layer and the support member, the bonding layer(s) having a tendency to form an oxide thereon, positioning the assembly of the support member, the chip and the bonding layer(s) in an evacuable chamber (18) without any liquid flux on the bonding layer(s), introducing gas into the chamber so that oxidation of the bonding layer is minimized, and heating the bonding layer(s) to above the melting point thereof, characterised in that the said gas functions as a reducing gas to reduce the oxide(s) on the said bonding layer(s) with the consequent generation of a gaseous reduction product, in that the pressure in the chamber is reduced to a subatmospheric pressure(s) in order to decrease the partial pressure of the said gaseous reduction product, in that the parts of the assembly can be brought into contact at any time, and in that the gas, the temperature of the heating, and the reduced pressure are such that the said gas functions as the reducing gas.

2. The method of claim 1, characterised in that said bonding layer material comprises a tin alloy, or indium.

3. The method of claim 2, characterised in that said gas comprises $H_2$ or CO.

4. The method of claim 3, characterised in that the partial pressure of water vapor $P_{H_2O}$ and the partial pressure of hydrogen $P_{H_2}$ are related as

$$P_{H_2O}/P_{H_2} \leq 1 \times 10^{-2}$$

when using the tin alloy, and $\leq 9 \times 10^{-5}$ when using indium; or the partial pressure of carbon dioxide $P_{CO_2}$ and the partial pressure of carbon monoxide $P_{CO}$ are related as

$$P_{CO_2}/P_{CO} \leq 1.08$$

when using tin alloy, and $\leq 2 \times 10^{-2}$ when using indium.

5. The method of claim 4, characterised in that when using indium, the pressure of the chamber is reduced to at least about $1.33 \times 10^{-3}$ Pa ($10^{-5}$ Torr) and either $P_{H_2}$ is at least about 10 Pa (100 μm Hg), or $P_{CO}$ is at least about 0.05 Pa (0.5 μm Hg).

6. The method of claim 10 for making a low strain bond, characterised in that the indium bonding layer is heated in hydrogen to a temperature of about 220—230°C, or in CO to a temperature of about 180—240°C and preferably 205—230°C.

7. The method of any one preceding claim, characterised in that the metal layer on the chip and metallization on the support member both comprise gold.

8. The method of any one preceding claim, characterised in that the chip comprises a semiconductor laser and the support member comprises a copper heat sink.

9. The method of any one preceding claim, characterised in that the bonding layer is heated by applying electrical current to the heat sink.

10. The method of any one preceding claim, characterised in that the chip is a double heterostructure comprising layers of material selected from the GaAs-AlGaAs and the InP-InGaAsP materials systems.

## Patentansprüche

1. Verfahren zum Herstellen eines Bauelementes, bei dem eine Metallschicht (14) auf einem mikroelektronischen Chip (10) an ein metallisiertes Tragglied (12) gebondet wird, wobei das Verfahren umfaßt

—Vorsehen einer weichen duktilen Bondschicht (16) auf wenigstens der Metallschicht oder dem Tragglied, wobei die Schicht(en) zur Bildung eines Oxids hierauf tendiert (tendieren),

—Positionieren der Anordnung aus Tragglied, Chip und Bondschicht(en) in einer evakuierbaren Kammer (18) ohne jedes flüssige Flußmittel auf der (den) Bondschicht(en),

—Einführen von Gas in die Kammer, so daß eine Oxidation der Bondschicht minimiert ist, und

—Erwärmen der Bondschicht(en) auf oberhalb deren Schmelzpunkt, dadurch gekennzeichnet, daß

—das Gas als ein reduzierendes Gas zur Reduktion von Oxid(en) auf der (den) Bondschicht(en) mit resultierender Erzeugung eines gasförmigen Reduktionsproduktes wirksam ist,

—der Druck der Kammer auf einen subatmosphärischen Druck oder auf subatmosphärische Drücke reduziert wird, um den Partialdruck des gasförmigen Reduktionsproduktes zu verringern,

—die Teile der Anordnung zu jeder Zeit in Kontakt miteinander gebracht werden können und

—das Gas, die Erwärmungstemperatur und der reduzierte Druck so gewählt sind, daß das Gas als das reduzierende Gas wirksam ist.

2. Verfahren nach Anspruch 1, dadurch gekennzeichnet, daß

—das Bondschichtmaterial eine Zinnlegierung oder Indium umfaßt.

3. Verfahren nach Anspruch 2, dadurch gekennzeichnet, daß

—das Gas $H_2$ oder CO umfaßt.

4. Verfahren nach Anspruch 3, dadurch gekennzeichnet, daß

—für den Partialdruck von Wasserdampf $P_{H_2O}$

und den Partialdruck von Wasserstoff $P_{H_2}$ die Beziehung gilt

$$P_{H_2O}/P_{H_2} \leq 1 \times 10^{-2},$$

wenn die Zinnlegierung benutzt wird, und

$$P_{H_2O}/P_{H_2} \leq 9 \times 10^{-5},$$

wenn Indium benutzt wird, oder

—für den Partialdruck von Kohlendioxid $P_{CO_2}$ und den Partialdruck von Kohlenmonoxid $P_{CO}$ die Beziehung gilt

$$P_{CO_2}/P_{CO} \leq 1.08,$$

wenn die Zinnlegierung benutzt wird, und

$$P_{CO_2}/P_{CO} \leq 2 \times 10^{-2},$$

wenn Indium benutzt wird.

5. Verfahren nach Anspruch 4, dadurch gekennzeichnet, daß

—bei Benutzung von Indium der Druck der Kammer auf wenigstens etwa $1,33 \times 10^{-3}$ Pa ($10^{-5}$ Torr) reduziert wird und entweder $P_{H_2}$ wenigstens etwa 13,3 Pa (100 μm Hg) oder $P_{CO}$ wenigstens etwa $6,7 \times 10^{-2}$ Pa (0,5 μm Hg) ist.

6. Verfahren nach Anspruch 10 zum Herstellen einer Bondstelle niedriger Dehnung, dadurch gekennzeichnet, daß die Indiumbondschicht in Wasserstoff auf eine Temperatur von etwa 220—230°C oder in CO auf eine Temperatur von etwa 180—240°C und vorzugsweise 205—230°C erhitzt wird.

7. Verfahren nach einem der vorstehenden Ansprüche, dadurch gekennzeichnet, daß die Metallschicht auf dem Chip und die Metallisierung auf dem Tragglied beide Gold umfassen.

8. Verfahren nach einem der vorstehenden Ansprüche, dadurch gekennzeichnet, daß das Chip einen Halbleiterlaser umfaßt und das Tragglied eine Kupferwärmesenke umfaßt.

9. Verfahren nach einem der vorstehenden Ansprüche, dadurch gekennzeichnet, daß die Bondschicht durch Zufuhr von elektrischem Strom zur Wärmesenke erwärmt wird.

10. Verfahren nach einem der vorstehenden Ansprüche, dadurch gekennzeichnet, daß das Chip eine Doppelheterostruktur mit Schichten aus einem Material ist, die aus den GaAs-AlGaAs- und den InP-InGaAsP-Materialsystemen ausgewählt sind.

## Revendications

1. Un procédé de fabrication d'un dispositif dans lequel une couche de métal (14) formée sur une puce microélectronique (10) est brasée sur un élément de support métallisé (12), dans lequel on forme une couche de brasage tendre et ductile (16) sur l'un au moins des éléments comprenant la couche de métal et l'élément de support, la ou les couches de brasage ayant tendance à former un oxyde, on positionne l'ensemble de l'élément de support, de la puce et de la couche ou des couches de brasage dans une chambre (18) dans laquelle on peut faire le vide, sans aucun flux liquide sur la ou les couches de brasage, on introduit un gaz dans la chambre de façon à minimiser l'oxydation de la couche de brasage, et on chauffe la ou les couches de brasage au-dessus de leur point de fusion, caractérisé en ce que ce gaz remplit la fonction d'un gaz réducteur pour réduire le ou les oxydes sur la ou les couches de brasage, ce qui s'accompagne par la génération d'un produit de réduction gazeux, en ce que la pression dans la chambre est réduite à une ou plusieurs valeurs de pressions inférieures à la pression atmosphérique, dans le but de diminuer la pression partielle du produit de réaction gazeux, en ce que les éléments de l'ensemble peut être amenés en contact à n'importe quel moment, et en ce que le gaz, la température de chauffage et la pression réduite sont choisis de façon que ce gaz remplisse la fonction du gaz réducteur.

2. Le procédé de la revendication 1, caractérisé en ce que le matériau de la couche de brasage consiste en un alliage d'étain ou en indium.

3. Le procédé de la revendication 2, caractérisé en ce que le gaz précité consiste en $H_2$ ou CO.

4. Le procédé de la revendication 3, caractérisé en ce que la pression partielle de vapeur d'eau $P_{H_2O}$ et la pression partielle d'hydrogène $P_{H_2}$ sont liées par la relation:

$$P_{H_2}/P_{H_2}O \leq 1 \times 10^{-2},$$

lorsqu'on utilise l'alliage d'étain, et $\leq 9 \times 10^{-5}$ lorsqu'on utilise l'indium; ou bien la pression partielle de dioxyde de carbone $P_{CO_2}$ et la pression partielle de monoxyde de carbone $P_{CO}$ sont liées par la relation

$$P_{CO_2}/P_{CO} \leq 1,08$$

lorsqu'on utilise un alliage d'étain, et $\leq 2 \times 10^{-2}$ lorsqu'on utilise l'indium.

5. Le procédé de la revendication 4, caractérisé en ce que lorsqu'on utilise l'indium, on réduit la pression dans la chambre à au moins $1,33 \times 10^{-3}$ Pa ($10^{-5}$ torr), et $P_{H_2}$ est au moins égale à environ 10 Pa (100 µm Hg), ou bien $P_{CO}$ est au moins égale à environ 0,05 Pa (0,5 µm Hg).

6. Le procédé de la revendication 10 pour réaliser une brasure à faibles contraintes, caractérisé en ce qu'on chauffe la couche de brasage en indium dans de l'hydrogène à une température d'environ 220—230°C, ou dans CO à une température d'environ 180—240°C, et de préférence de 205—230°C.

7. Le procédé selon l'une quelconque des revendications précédentes, caractérisé en ce que la couche de métal sur la puce et la métallisation sur l'élément de support sont toutes deux en or.

8. Le procédé selon l'une quelconque des revendications précédentes, caractérisé en ce que la puce consiste en un laser à semiconducteur et l'élément de support consiste en un radiateur en cuivre.

9. Le procédé selon l'une quelconque des revendications précédentes, caractérisé en ce qu'on chauffe la couche de brasage en appliquant un courant électrique au radiateur.

10. Le procédé selon l'une quelconque des revendications précédentes, caractérisé en ce que la puce consiste en une double hétérostructure comprenant des couches de matériaux sélectionnés parmi les systèmes de matériaux GaAs-AlGaAs et InP-InGaAsP.

FIG.1

FIG.2

FIG.3